Europäisches Patentamt

European Patent Office

Office européen des brevets

(19)

(11) **EP 0 847 143 A1**

## (12) DEMANDE DE BREVET EUROPEEN

(43) Date de publication:
**10.06.1998 Bulletin 1998/24**

(51) Int. Cl.⁶: **H03L 7/091**, H03L 7/181

(21) Numéro de dépôt: **97203645.3**

(22) Date de dépôt: **21.11.1997**

(84) Etats contractants désignés:
**AT BE CH DE DK ES FI FR GB GR IE IT LI LU MC
NL PT SE**
Etats d'extension désignés:
**AL LT LV MK RO SI**

(30) Priorité: **03.12.1996 FR 9614797**

(71) Demandeur:
**Philips Electronics N.V.
5621 BA Eindhoven (NL)**

(72) Inventeur: **Martinez, Georges
75008 Paris (FR)**

(74) Mandataire: **Caron, Jean
Société Civile S.P.I.D.
156, Boulevard Haussmann
75008 Paris (FR)**

### (54) Synthétiseur de fréquence programmable à faible sensibilité au bruit de phase

(57)   La présente invention concerne un synthétiseur de fréquence SYNT destiné à fournir un signal de sortie Sout possédant une fréquence de sortie qui dépend de la fréquence moyenne, dite fréquence symbole, d'un signal d'entrée Sin affecté d'un fort bruit de phase. Ce synthétiseur SYNT comprend :

. un détecteur de phase/fréquence PHD comparant la fréquence symbole avec une fraction prédéterminée de la fréquence de sortie, et fournit un signal de commande,
. un filtre passe-bas LPF filtrant ledit signal,

.   un oscillateur VCO fournissant un signal Sout dont la fréquence est ajustée par le signal de commande Cs.

Selon l'invention, des impulsions de référence ayant pour fréquence la fréquence symbole sont générées au sein du synthétiseur SYNT, au moyen d'impulsions provenant d'une horloge interne validées par des états actifs du signal d'entrée Sin.

Applications : modulation/démodulation de données numériques.

FIG.1

## Description

La présente invention concerne un synthétiseur de fréquence, destiné à recevoir un signal d'entrée possédant une fréquence moyenne dite fréquence symbole, un signal d'horloge dont la fréquence est fixe, et à fournir un signal de sortie possédant une fréquence dite fréquence de sortie, comprenant :

. un détecteur de phase/fréquence destiné à comparer la fréquence symbole avec une fraction prédéterminée de la fréquence de sortie, et à fournir un signal de commande en vue d'ajuster la valeur de ladite fréquence de sortie,
. un filtre passe-bas muni d'une sortie et d'une entrée destinée à recevoir le signal de commande,
. un oscillateur muni d'une entrée de réglage reliée à la sortie du filtre passe-bas et d'une sortie destinée à fournir le signal de sortie du synthétiseur dont la fréquence de sortie dépend du signal présent à l'entrée de réglage.

Un tel synthétiseur de fréquence est connu de la demande de brevet européen No. EP 0 727 877 A2. Ce synthétiseur contient un premier et un deuxième diviseurs programmables qui fournissent en sortie des signaux dont les fréquences présentent par rapport à la fréquence de sortie et par rapport à la fréquence symbole, respectivement, un premier et un deuxième taux de division, lesquels sont programmables par voie logicielle. Les fréquences des signaux de sortie des diviseurs programmables sont comparées au moyen d'un détecteur de phase/fréquence qui fournit un signal de commande destiné à ajuster la fréquence de sortie afin que le rapport entre celle-ci et la fréquence symbole soit égal au rapport entre les premier et deuxième taux de division. Le signal d'entrée de ce synthétiseur est ici un signal de référence dont la fréquence est connue et invariable, constituant la fréquence symbole. Dans certaines applications, en particulier dans le cadre de la réception de signaux depuis un réseau de communication, le signal d'entrée, élaboré sur la base des dits signaux, peut présenter un bruit de phase qui se manifeste par des variations de rapport cyclique et de fréquence autour d'une fréquence moyenne qui correspond à la fréquence symbole. Les fronts actifs d'un tel signal ne peuvent donc plus servir d'impulsions de référence comme c'est le cas dans le synthétiseur de fréquence connu décrit ci-dessus.

La présente invention a pour but de remédier à cet inconvénient en proposant un synthétiseur de fréquence dans lequel des fronts actifs du signal d'horloge validés par des états logiques actifs du signal d'entrée constituent les impulsions de référence, dont la fréquence moyenne est la fréquence symbole.

En effet, un synthétiseur de fréquence selon l'invention est caractérisé en ce que le détecteur de phase/fréquence comporte :

. un module de temporisation destiné à délivrer un signal dit signal de fin de cycle prenant un état actif à l'issue d'une durée appelée cycle de comptage égale au produit de la durée d'une période du signal de sortie du synthétiseur par une première valeur numérique prédéterminée,
. un dispositif de comptage présentant une entrée d'horloge destinée à recevoir le signal d'horloge, une sortie dont la valeur est incrémentée, lorsque le dispositif de comptage est activé, à chaque nouvelle période du dit signal d'horloge, le dispositif de comptage n'étant activé que lorsque le signal d'entrée du synthétiseur présente un état logique actif, la valeur de la sortie du dispositif de comptage étant ré-initialisée lorsque le signal de fin de cycle est à l'état actif,
. des moyens de comparaison permettant de comparer la valeur obtenue à la sortie du dispositif de comptage à l'issue du cycle de comptage avec une deuxième valeur numérique prédéterminée, le résultat de cette comparaison servant à générer le signal de commande.

Dans un tel synthétiseur de fréquence, le dispositif de comptage mesure le nombre d'impulsions de référence, dont la fréquence moyenne est la fréquence symbole notée Fsym, survenant pendant un cycle de comptage, dont la durée est délimitée par la première valeur numérique prédéterminée Ref1, et dépend de la période du signal de sortie. Si, dans un mode transitoire, ce nombre d'impulsions de référence est inférieur à la deuxième valeur numérique prédéterminée Ref2, le signal de commande agit sur l'oscillateur de manière à ce que la fréquence de sortie devienne suffisamment faible pour que la valeur obtenue en sortie du dispositif de comptage soit égale, dans un mode permanent atteint au bout d'un certain nombre de cycles de comptage, à la deuxième valeur numérique prédéterminée. Les conditions d'obtention de ce mode permanent peuvent donc être décrites par l'équation Fout=Fsym.Ref1/Ref2. Les valeurs de Ref1 et Ref2, pouvant par exemple provenir de registres, programmables par voie logicielle, permettent d'ajuster avec une grande flexibilité la valeur de la fréquence de sortie du synthétiseur.

Un mode de réalisation de l'invention présente un synthétiseur de fréquence tel que décrit ci-dessus, caractérisé en ce que le dispositif de comptage comporte un premier compteur muni d'une entrée d'horloge destinée à recevoir le signal d'horloge, d'une sortie formant la sortie du dispositif de comptage, d'une entrée d'autorisation de comptage destinée à recevoir le signal d'entrée, d'une entrée de chargement dont le bit de poids le plus faible est relié à la dite entrée d'autorisation et dont les autres bits sont placés à l'état logique inactif, et d'une entrée de ré-initialisation destinée à recevoir le signal de fin de cycle dont un état actif commande le chargement en sortie du compteur de la valeur présente à son entrée de chargement.

Le mode de ré-initialisation mis en oeuvre dans un tel dispositif de comptage permet de garder trace d'un état actif du signal d'entrée qui, en cas de remise à zéro pure et simple du premier compteur en fin de cycle de comptage, ne serait pas enregistré par le compteur si la fin du cycle de comptage survenait avant le front actif du signal d'horloge. Il en résulterait une erreur entre la fréquence des impulsions de référence et la valeur réelle de la fréquence symbole.

Dans un autre mode de réalisation de l'invention, un synthétiseur de fréquence selon l'invention est caractérisé en ce que les moyens de comparaison inclus dans le détecteur de phase/fréquence comprennent un premier soustracteur numérique muni d'une première entrée destinée à recevoir la sortie du dispositif de comptage, d'une deuxième entrée destinée à recevoir la deuxième valeur numérique prédéterminée, et d'une sortie reliée à un premier registre mémorisant l'état de la dite sortie à l'issue de chaque cycle de comptage, premier registre destiné à fournir un signal servant à générer le signal de commande.

Le fait de procéder à une soustraction et non à une simple comparaison entre la sortie du dispositif de comptage et la deuxième valeur numérique prédéterminée donne une information sur l'ampleur de la correction à apporter à la fréquence de sortie, ce qui peut permettre au synthétiseur d'aboutir plus rapidement au régime permanent.

Dans un mode de réalisation particulier de l'invention, un synthétiseur de fréquence tel que décrit plus haut est caractérisé en ce que le module de temporisation comporte un deuxième compteur muni d'une entrée d'horloge destinée à recevoir le signal de sortie du synthétiseur, d'une entrée de remise à zéro et d'une sortie, un comparateur numérique muni d'une première entrée destinée à recevoir la première valeur numérique prédéterminée, d'une deuxième entrée reliée à la sortie du deuxième compteur, et d'une sortie reliée à l'entrée de remise à zéro et destinée à délivrer le signal de fin de cycle prenant un état actif lorsque les valeurs des signaux reçus sur les entrées du comparateur sont égales.

Le signal stocké dans le premier registre est constitué d'un certain nombre de bits, dont seuls quelques-uns sont significatifs en mode de fonctionnement normal du synthétiseur. En effet, à mesure que celui-ci approche de son mode permanent, les différences entre les ampleurs des corrections successives s'amenuisent. Il peut donc être avantageux de prévoir, au sein du module de commande, un dispositif effectuant une comparaison entre le contenu du premier registre à l'issue d'un cycle de comptage et l'ampleur de la correction commandée à l'issue du cycle précédent.

Une variante de l'invention présente donc un synthétiseur de fréquence tel que décrit plus haut, caractérisé en ce que le détecteur de phase/fréquence comporte un module de commande comprenant un deuxième registre muni d'une sortie de données sur laquelle est prélevé le signal de commande, et un deuxième soustracteur numérique muni d'une première entrée reliée à la sortie de données du premier registre, d'une deuxième entrée reliée à la sortie de données du deuxième registre, et d'une sortie dont l'état est mémorisé dans le deuxième registre au rythme de la fréquence du signal d'horloge.

Un compromis doit être trouvé entre la précision de la correction que l'on souhaite obtenir, qui se traduira par le nombre des bits les plus significatifs que l'on prélèvera en sortie du deuxième registre, et la simplicité de la structure du synthétiseur. En effet, le signal de commande numérique obtenu en sortie du deuxième registre devra être converti en un signal analogique avant d'être envoyé au filtre passe-bas, puis à l'entrée de réglage de l'oscillateur. Cette conversion est réalisée au moyen d'un convertisseur numérique/analogique, dont la structure est d'autant plus complexe que la taille du mot numérique à convertir est grande. Dans un cas particulier, on peut se contenter de choisir le bit de signe de la sortie du deuxième registre pour constituer le signal de commande, ce qui permet d'éviter le recours à une conversion numérique/analogique.

Un mode de réalisation particulier de l'invention présente donc un synthétiseur de fréquence tel que décrit ci-dessus, caractérisé en ce que le signal de commande est constitué par le bit indiquant le signe du signal présent à la sortie de données du deuxième registre.

Un tel synthétiseur est particulièrement bien adapté à des applications de réception, depuis un réseau de communication, de signaux desquels est extrait le signal d'entrée qui peut avoir servi à l'élaboration des signaux reçus, applications dans lesquelles on souhaite générer un nouveau signal sur la base du signal d'entrée afin de cadencer la modulation d'un signal à renvoyer vers le réseau de communication. L'invention concerne donc également un dispositif d'interface entre un terminal et un réseau de communication au travers duquel circulent des données numériques, comprenant :

. un module destiné à générer un signal d'horloge interne au dispositif,
. un syntoniseur permettant de sélectionner un signal de données provenant du réseau,
. un démodulateur numérique cadencé par le signal d'horloge, destiné à recevoir le signal de données provenant du réseau et à générer, à partir du dit signal, un signal possédant une fréquence moyenne dite fréquence symbole et un signal de données démodulé,
. un premier et un deuxième registres destinés à contenir respectivement une première et une deuxième valeurs prédéterminées,
. un synthétiseur de fréquence destiné à générer un signal possédant une fréquence dite de sortie, le rapport entre la fréquence de sortie et la fréquence symbole étant sensiblement égale au rapport entre les première et deuxième valeurs prédéterminées,

. un modulateur numérique cadencé par le signal de sortie du synthétiseur de fréquence et destiné à émettre vers le réseau un autre signal de données, caractérisé en ce que le synthétiseur de fréquence est tel que décrit plus haut.

L'invention sera mieux comprise à l'aide de la description suivante de quelques modes de réalisation, faite à titre d'exemple non-limitatif et en regard des dessins annexés, dans lesquels :

- la figure 1 représente un schéma décrivant partiellement un synthétiseur de fréquence selon un mode de l'invention,
- la figure 2 représente un schéma décrivant partiellement un dispositif de comptage inclus dans un synthétiseur de fréquence selon un autre mode de réalisation de l'invention,
- la figure 3 représente un schéma décrivant partiellement un module de commande inclus dans un synthétiseur de fréquence selon une variante de l'invention, et
- la figure 4 représente un schéma décrivant partiellement un dispositif d'interface comprenant un synthétiseur de fréquence selon l'invention.

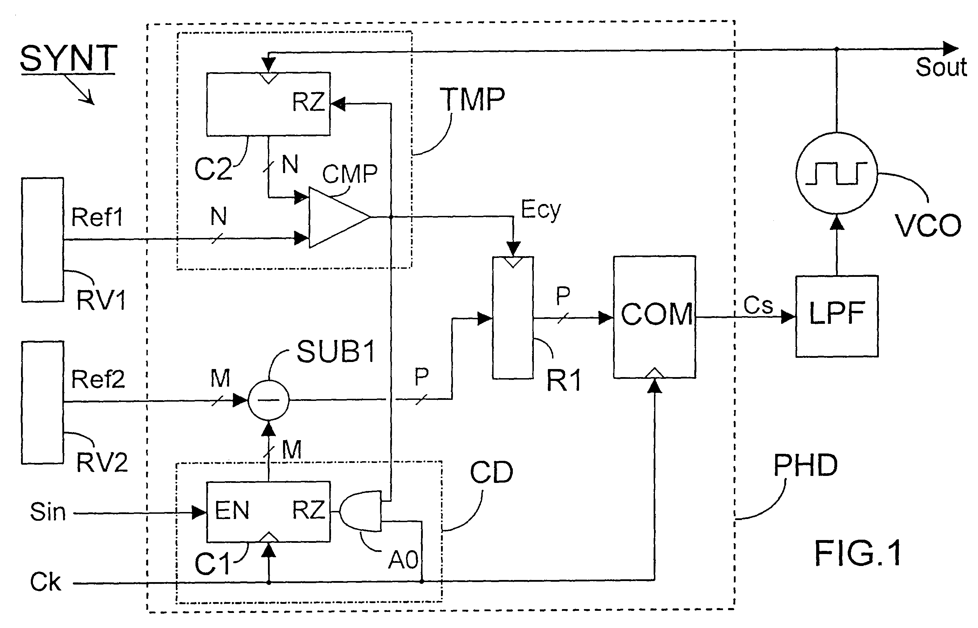

La figure 1 est un schéma électrique partiel d'un synthétiseur de fréquence SYNT selon l'invention, destiné à recevoir un signal d'entrée Sin possédant une fréquence moyenne Fsym dite fréquence symbole, un signal d'horloge Ck dont la fréquence est fixe, et à fournir un signal de sortie Sout possédant une fréquence dite fréquence de sortie Fout. Ce synthétiseur SYNT comprend :

. un détecteur de phase/fréquence PHD destiné à comparer la fréquence symbole Fsym avec une fraction prédéterminée de la fréquence de sortie Fout, et à fournir un signal de commande Cs en vue d'ajuster la valeur de ladite fréquence de sortie Fout,

. un filtre passe-bas LPF muni d'une sortie et d'une entrée destinée à recevoir le signal de commande Cs,

. un oscillateur VCO muni d'une entrée de réglage reliée à la sortie du filtre passe-bas LPF et d'une sortie destinée à fournir le signal de sortie Sout du synthétiseur SYNT, dont la fréquence de sortie Fout dépend du signal présent à l'entrée de réglage. Dans ce synthétiseur de fréquence SYNT, le détecteur de phase/fréquence PHD comporte :

. un module de temporisation TMP destiné à délivrer un signal Ecy dit signal de fin de cycle prenant un état actif à l'issue d'une durée appelée cycle de comptage égale au produit de la durée d'une période du signal de sortie Fout du synthétiseur SYNT par une première valeur numérique prédéterminée Ref1,

. un dispositif de comptage CD présentant une entrée d'horloge destinée à recevoir le signal d'horloge Ck, une sortie dont la valeur est incrémentée, lorsque le dispositif de comptage CD est activé, à chaque nouvelle période du dit signal d'horloge, le dispositif de comptage n'étant activé que lorsque le signal d'entrée du synthétiseur présente un état logique actif, la valeur de la sortie du dispositif de comptage étant ré-initialisée lorsque le signal de fin de cycle est à l'état actif,

. des moyens de comparaison SUB1 permettant de comparer la valeur obtenue à la sortie du dispositif de comptage à l'issue du cycle de comptage avec une deuxième valeur numérique prédéterminée Ref2, le résultat de cette comparaison servant à générer le signal de commande Cs.

Dans ce mode de réalisation particulier, le dispositif de comptage CD comporte un premier compteur C1 muni d'une entrée d'horloge recevant le signal d'horloge Ck, d'une sortie codée sur M bits formant la sortie du dispositif de comptage CD, d'une entrée d'autorisation de comptage EN destinée à recevoir le signal d'entrée Sin, d'une entrée de remise à zéro RZ reliée à la sortie d'une porte ET logique deux entrées A0, laquelle reçoit sur une entrée le signal de fin de cycle Ecy et sur l'autre le signal d'horloge Ck.

Le module de temporisation TMP comporte un deuxième compteur C2 muni d'une entrée d'horloge destinée à recevoir le signal de sortie Sout du synthétiseur SYNT, d'une entrée de remise à zéro RZ et d'une sortie codée sur N bits. Le module de temporisation TMP comporte en outre un comparateur numérique CMP muni d'une première entrée destinée à recevoir la première valeur numérique prédéterminée Ref1, provenant ici d'un registre RV1 de N bits, d'une deuxième entrée reliée à la sortie du deuxième compteur C2, et d'une sortie reliée à l'entrée de remise à zéro RZ et destinée à délivrer le signal de fin de cycle Ecy, qui prend un état actif lorsque les valeurs des signaux reçus sur les entrées du comparateur CMP sont égales.

Les moyens de comparaison inclus dans le détecteur de phase/fréquence PHD comprennent un premier soustracteur numérique SUB1 muni d'une première entrée destinée à recevoir la sortie du premier compteur C1, d'une deuxième entrée destinée à recevoir la deuxième valeur numérique prédéterminée Ref2, provenant ici d'un registre RV2 de M bits, et d'une sortie codée sur P bits et reliée à un premier registre R1 de P bits et cadencé par le signal de fin de cycle Ecy. Le module de commande COM reçoit la sortie du registre R1 et génère le signal de commande Cs.

En mode transitoire, le compteur C1 compte le nombre d'impulsions de référence, c'est-à-dire le nombre de fronts actifs du signal d'horloge Ck validés par un état actif du signal d'entrée Sin, dont la fréquence moyenne est la fréquence symbole Fsym, qui surviennent pendant un cycle de comptage. La durée du cycle de comptage est égale à Ref1/Fout, où Fout est la fréquence du signal de sortie Sout. La sortie du compteur C1 est en permanence comparée à la deuxième valeur numérique prédéterminée Ref2 au moyen du soustracteur SUB1, dont la sortie indique l'ampleur de la différence entre Ref2 et la valeur de la sortie du compteur C1. A la fin du cycle de comptage, la sortie du comparateur CMP prend l'état logique actif et provoque la remise à zéro du deuxième compteur C2. Celle-ci ayant été effectuée, et après une nouvelle comparaison, la sortie du comparateur CMP revient à l'état logique inactif. Cette impulsion en sortie du comparateur CMP se traduit donc par un front actif du signal de fin de cycle Ecy, qui provoque la mémorisation de la sortie du soustracteur SUB1, puis, au front actif du signal d'horloge suivant, une remise à zéro du premier compteur C1. Le contenu du registre R1 rend compte de l'ampleur de la correction à apporter à la fréquence de sortie. Le module de commande COM génère donc, sur la base de la valeur contenue dans le registre R1, un signal de commande Cs permettant d'ajuster la valeur de la fréquence de sortie en vue d'obtenir la valeur zéro en sortie du soustracteur SUB1 à l'issue d'un cycle de comptage. Si, par exemple, la valeur de la sortie du premier compteur C1 est inférieure à la deuxième valeur numérique de référence Ref2 à la fin du cycle de comptage, le signal de commande Cs agit sur l'oscillateur VCO de manière à ce que la valeur de sortie du soustracteur SUB1 se rapproche de zéro à l'issue du cycle de comptage suivant. Au bout d'un certain nombre de cycles de comptage, un mode permanent est atteint, dans lequel la valeur de sortie du soustracteur SUB1 est, en moyenne, nulle à la fin de chaque cycle de comptage. Les conditions d'obtention de ce mode permanent peuvent donc être décrites par l'équation Fout=Fsym.Ref1/Ref2 .

La remise à zéro du premier compteur C1 en fin de cycle de comptage peut induire une erreur dans la valeur de la fréquence symbole telle que décrite ci-dessus. En effet, celle-ci doit être représentative d'une moyenne statistique des variations de la fréquence du signal d'entrée Sin. Or, si un état actif du signal de fin de cycle Ecy survient avant un front actif du signal d'horloge Ck pendant un état actif du signal d'entrée Sin, ce dernier ne pourra engendrer une impulsion de référence à comptabiliser par le premier compteur C1, car la sortie du dit compteur sera remise à l'état logique inactif au prochain front actif du signal d'horloge Ck. Il est donc souhaitable de mémoriser l'état logique que présente le signal d'entrée Sin au moment où le premier compteur C1 est ré-initialisé, de manière à ce que la sortie du dit compteur soit bien représentative du nombre d'impulsions de référence reçues.

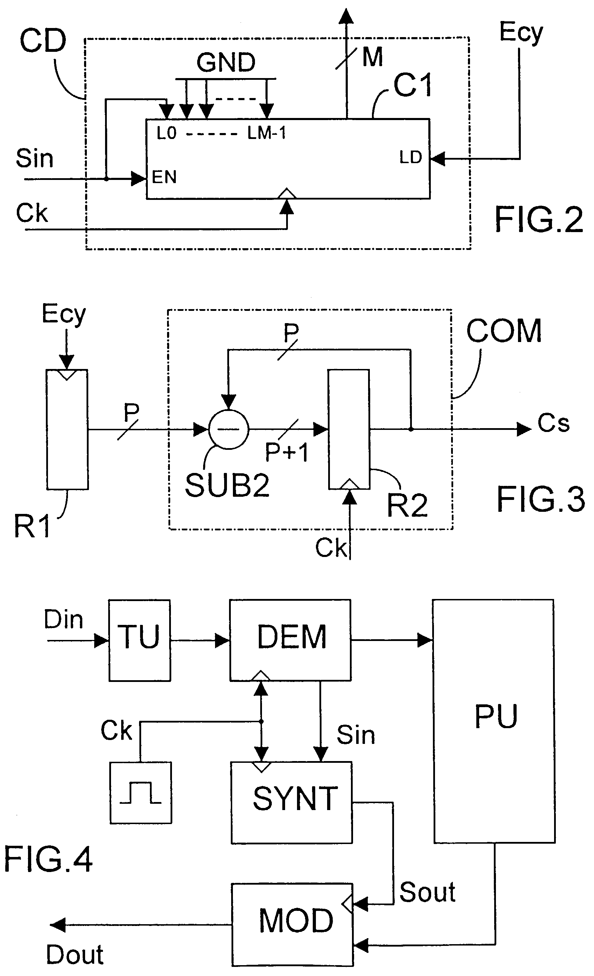

La figure 2 est un schéma électrique partiel d'un dispositif de comptage dans lequel l'état logique que présente le signal d'entrée Sin au moment où le premier compteur C1 est réinitialisé est mémorisé. Dans ce dispositif, le premier compteur C1 est muni d'une entrée de chargement L[0:M-1], dont le bit de poids le plus faible L0 reçoit le signal d'entrée Sin et dont les autres bits L1,...LM-1 sont placés à l'état logique inactif, constitué ici par le potentiel GND de la masse du circuit, Le premier compteur C1 est en outre muni d'une entrée de ré-initialisation LD destinée à recevoir le signal de fin de cycle Ecy. Un état actif sur l'entrée LD commande le chargement en sortie du compteur de la valeur présente à son entrée de chargement L[0:M-1]. Ainsi, en fin de cycle de comptage, l'état logique du signal d'entrée Sin est mémorisé et constitue l'état du bit de poids le plus faible de la sortie du premier compteur C1 au début de son nouveau cycle de comptage.

Le signal stocké dans le premier registre R1 est constitué de P bits, dont, le plus souvent, seuls quelques-uns sont significatifs. En effet, à mesure que le synthétiseur approche de son mode permanent, les différences entre les ampleurs des corrections successives, et donc entre les contenus successifs du registre R1, s'amenuisent. Il peut donc être avantageux de prévoir, au sein du module de commande COM, un dispositif effectuant une comparaison entre le contenu du premier registre R1 à l'issue d'un cycle de comptage et l'ampleur de la correction commandée à l'issue du cycle précédent.

La figure 3 est un schéma électrique partiel d'un module de commande intégrant un tel dispositif. Ce module de commande comprend un deuxième registre R2 muni d'une sortie de données codée sur P+1 bits fournissant le signal de commande Cs, et un deuxième soustracteur numérique SUB2 muni d'une première entrée de P bits reliée à la sortie de données du premier registre R1, d'une deuxième entrée de P bits recevant les P bits les moins significatifs de la sortie de données du deuxième registre R2, et d'une sortie codée sur P+1 bits, le bit supplémentaire étant un bit de signe et constituant donc le bit le plus significatif de la sortie du soustracteur SUB2. L'état de cette sortie est mémorisé dans le deuxième registre R2 au rythme de la fréquence du signal d'horloge Ck.

Un compromis doit être trouvé entre la précision de la correction que l'on souhaite obtenir, qui se traduit par le nombre des bits les plus significatifs que l'on prélève en sortie du deuxième registre R2, et la simplicité de la structure du synthétiseur. En effet, le signal de commande numérique Cs obtenu en sortie du deuxième registre R2 doit, en principe, être converti en un signal analogique avant d'être envoyé au filtre passe-bas LPF, puis à l'entrée de réglage de l'oscillateur VCO. Cette conversion est alors réalisée au moyen d'un convertisseur numérique/analogique, dont la structure est d'autant plus complexe que la taille du mot numérique à convertir est grande. Dans le cas particulier illustré à la figure 3, seul le bit de signe de la sortie du deuxième registre R2 est choisi pour constituer le signal de commande Cs, ce qui permet d'éviter le recours à une conversion numérique/analogique. Lorsque le synthétiseur se trouve au début du mode transitoire tel que décrit plus haut, la valeur de sortie du registre R1 est grande, puisque représentative de l'écart entre la valeur de la sortie du premier compteur C1 à l'issue du cycle de comptage et la deuxième valeur numérique prédéterminée Ref2. S'il s'agit du premier cycle, le contenu du registre R2 est nul par hypothèse, du fait de l'initialisation du système. La valeur de la sortie du deuxième soustracteur SUB2 sera donc négative et grande en valeur absolue. Le bit de signe Cs prend donc l'état actif, et l'oscillateur VCO reçoit une commande provoquant la diminution de la fréquence de sortie Fout. A l'issue du cycle suivant, l'écart entre la valeur de la sortie du premier compteur C1 et la deuxième valeur numérique prédéterminée Ref s'est réduit, et la valeur de sortie du premier registre R1 est plus faible. La valeur de la sortie du deuxième soustracteur SUB2 devient donc positive et petite en valeur absolue. Le bit de signe Cs revient à l'état inactif, ne provoquant pas de changement de la fréquence de sortie Fout. A l'issue du cycle suivant, l'écart entre la valeur de la sortie du premier compteur C1 et la deuxième valeur numérique prédéterminée Ref2 est sensiblement inchangé, de sorte que la valeur de sortie du premier registre R1 est donc sensiblement identique à celle du cycle précédent, tandis que la valeur absolue de la sortie du deuxième registre R2 a considérablement diminué du fait de la précédente soustraction. La valeur de la sortie du soustracteur SUB2 redevient donc négative et relativement importante en valeur absolue, quoique plus faible que lors de la première itération. Le bit de signe Cs prend donc l'état actif, et l'oscillateur VCO reçoit une commande provoquant la diminution de la fréquence de sortie Fout. Le synthétiseur évolue ainsi par itérations successives jusqu'à atteindre le mode permanent. Le filtre passe-bas LPF provoque un effet de moyenne et permet de lisser le signal de commande, en atténuant le caractère brutal des impulsions numériques constituant le signal de commande Cs, qui peut se révéler générateur de bruit et nuire à la précision du réglage et à la stabilité de la fréquence de sortie que l'on souhaite obtenir en mode permanent.

La figure 4 est un schéma électrique partiel d'un dispositif dans lequel l'invention est mise en oeuvre. Il s'agit d'un dispositif d'interface entre un terminal et un réseau de communication au travers duquel circulent des données numériques, comprenant :

. un module destiné à générer un signal d'horloge Ck interne au dispositif,
. un syntoniseur TU permettant de sélectionner un signal de données Din provenant du réseau,
. un démodulateur numérique DEM cadencé par le signal d'horloge Ck, destiné à recevoir le signal de données Din provenant du réseau et à générer, à partir du dit signal, un signal Sin possédant une fréquence moyenne Fsym dite fréquence symbole et un signal de données démodulé, lequel est destiné à être exploité par une unité de traitement PU du terminal,
. un synthétiseur de fréquence SYNT tel que décrit plus haut, destiné à générer un signal Sout possédant une fréquence de sortie Fout, réglable en fonction de la fréquence symbole Fsym,
. un modulateur numérique MOD cadencé par le signal de sortie Sout du synthétiseur de fréquence SYNT et destiné à émettre vers le réseau un autre signal de données Dout, élaboré dans cet exemple sur la base d'un signal provenant de l'unité de traitement PU.

L'utilisation du synthétiseur SYNT permet de moduler le signal à émettre au moyen du signal Sout dont la fréquence est fonction de la fréquence symbole Fsym. Le destinataire du signal de données Dout ainsi émis sera donc capable d'identifier aisément la fréquence à utiliser pour la démodulation du dit signal.

**Revendications**

1. Synthétiseur de fréquence, destiné à recevoir un signal d'entrée possédant une fréquence moyenne dite fréquence symbole, un signal d'horloge dont la fréquence est fixe, et à fournir un signal de sortie possédant une fréquence dite fréquence de sortie, synthétiseur comprenant :

. un détecteur de phase/fréquence destiné à comparer la fréquence symbole avec une fraction prédéterminée de la fréquence de sortie, et à fournir un signal de commande en vue d'ajuster la valeur de ladite fréquence de sortie,
. un filtre passe-bas muni d'une sortie et d'une entrée destinée à recevoir le signal de commande,
. un oscillateur muni d'une entrée de réglage reliée à la sortie du filtre passe-bas et d'une sortie destinée à fournir le signal de sortie du synthétiseur dont la fréquence de sortie dépend du signal présent à l'entrée de réglage,
        caractérisé en ce que le détecteur de phase/fréquence comporte :
. un module de temporisation destiné à délivrer un signal dit signal de fin de cycle prenant un état actif à l'issue d'une durée appelée cycle de comptage égale au produit de la durée d'une période du signal de sortie du synthétiseur par une première valeur numérique prédéterminée,
. un dispositif de comptage présentant une entrée d'horloge destinée à recevoir le signal d'horloge, une sortie dont la valeur est incrémentée, lorsque le dispositif de comptage est activé, à chaque nouvelle période du dit signal d'horloge, le dispositif de comptage n'étant activé que lorsque le signal d'entrée du synthétiseur présente un état logique actif, la valeur de la sortie du dispositif de comptage étant réinitialisée lorsque le signal de fin de cycle est à l'état actif,

. des moyens de comparaison permettant de comparer la valeur obtenue à la sortie du dispositif de comptage à l'issue du cycle de comptage avec une deuxième valeur numérique prédéterminée, le résultat de cette comparaison servant à générer le signal de commande.

2. Synthétiseur de fréquence selon la revendication 1, caractérisé en ce que le dispositif de comptage comporte un premier compteur muni d'une entrée d'horloge destinée à recevoir le signal d'horloge, d'une sortie formant la sortie du dispositif de comptage, d'une entrée d'autorisation de comptage destinée à recevoir le signal d'entrée, d'une entrée de chargement dont le bit de poids le plus faible est relié à la dite entrée d'autorisation et dont les autres bits sont placés à l'état logique inactif, et d'une entrée de réinitialisation destinée à recevoir le signal de fin de cycle dont un état actif commande le chargement en sortie du compteur de la valeur présente à son entrée de chargement.

3. Synthétiseur de fréquence selon l'une des revendications 1 ou 2, caractérisé en ce que les moyens de comparaison inclus dans le détecteur de phase/fréquence comprennent un premier soustracteur numérique muni d'une première entrée destinée à recevoir la sortie du dispositif de comptage, d'une deuxième entrée destinée à recevoir la deuxième valeur numérique prédéterminée, et d'une sortie reliée à un premier registre mémorisant l'état de la dite sortie à l'issue de chaque cycle de comptage, premier registre destiné à fournir un signal servant à générer le signal de commande.

4. Synthétiseur de fréquence selon l'une quelconque des revendications 1 à 3, caractérisé en ce que le module de temporisation comporte un deuxième compteur muni d'une entrée d'horloge destinée à recevoir le signal de sortie du synthétiseur, d'une entrée de remise à zéro et d'une sortie, un comparateur numérique muni d'une première entrée destinée à recevoir la première valeur numérique prédéterminée, d'une deuxième entrée reliée à la sortie du deuxième compteur, et d'une sortie reliée à l'entrée de remise à zéro et destinée à délivrer le signal de fin de cycle prenant un état actif lorsque les valeurs des signaux reçus sur les entrées du comparateur sont égales.

5. Synthétiseur de fréquence selon l'une quelconque des revendications 3 ou 4, caractérisé en ce que le détecteur de phase/fréquence comporte un module de commande comprenant un deuxième registre muni d'une sortie de données sur laquelle est prélevé le signal de commande, et un deuxième soustracteur numérique muni d'une première entrée reliée à la sortie de données du premier registre, d'une deuxième entrée reliée à la sortie de données du deuxième registre, et d'une sortie dont l'état est mémorisé dans le deuxième registre au rythme de la fréquence du signal d'horloge.

6. Synthétiseur de fréquence selon la revendication 5, caractérisé en ce que le signal de commande est constitué par le bit indiquant le signe du signal présent à la sortie de données du deuxième registre.

7. Dispositif d'interface entre un terminal et un réseau de communication au travers duquel circulent des données numériques, comprenant :

. un module destiné à générer un signal d'horloge interne au dispositif,

. un syntoniseur permettant de sélectionner un signal de données provenant du réseau,

. un démodulateur numérique cadencé par le signal d'horloge, destiné à recevoir le signal de données provenant du réseau et à générer, à partir du dit signal, un signal possédant une fréquence moyenne dite fréquence symbole et un signal de données démodulé,

. un premier et un deuxième registres destinés à contenir respectivement une première et une deuxième valeurs prédéterminées,

. un synthétiseur de fréquence destiné à générer un signal possédant une fréquence dite de sortie, le rapport entre la fréquence de sortie et la fréquence symbole étant sensiblement égale au rapport entre les première et deuxième valeurs prédéterminées,

. un modulateur numérique cadencé par le signal de sortie du synthétiseur de fréquence et destiné à émettre vers le réseau un autre signal de données,

caractérisé en ce que le synthétiseur de fréquence est conforme à l'une quelconque des revendications 1 à 6.

FIG.1

SYNT

EP 0 847 143 A1

FIG.2

FIG.3

FIG.4

**Office européen des brevets**

# RAPPORT DE RECHERCHE EUROPEENNE

Numéro de la demande

EP 97 20 3645

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 278 874 A (LIU CLIF ET AL) 11 janvier 1994 * colonne 3, ligne 14 - colonne 10, ligne 68; figures * | 1,2,7 | H03L7/091 H03L7/181 |
| A | GB 2 286 300 A (ADC TELECOMMUNICATIONS INC) 9 août 1995 * page 9, ligne 16 - page 10, ligne 2; figures 1,2 * | 1,7 | |
| A | GB 2 267 617 A (INT STANDARD ELECTRIC CORP) 8 décembre 1993 * page 4, ligne 6 - page 7, ligne 22; figures 2-5 * | 1,7 | |
| A | EP 0 321 725 A (SIEMENS AG) 28 juin 1989 * colonne 1, ligne 2 - ligne 34 * * colonne 6, ligne 40 - colonne 9, ligne 48; figures * | 1,7 | |
| A,D | EP 0 727 877 A (MATSUSHITA ELECTRIC IND CO LTD) 21 août 1996 * colonne 2, ligne 11 - ligne 41; figures * | 1 | **DOMAINES TECHNIQUES RECHERCHES (Int.Cl.6)** H03L |

Le présent rapport a été établi pour toutes les revendications

| Lieu de la recherche | Date d'achèvement de la recherche | Examinateur |
|---|---|---|
| LA HAYE | 25 février 1998 | Balbinot, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)